# EUROPEAN PATENT APPLICATION

(11) **EP 3 835 856 A1**
(43) Date of publication of application: **16.06.2021**
(21) Application number: 20213436.7
(22) Date of filing: 11.12.2020
(51) Int. Cl.: G02F 1/1333, H01L 25/075, H01L 33/52, H01L 33/62

(54) **DISPLAY APPARATUS HAVING DISPLAY MODULE AND METHOD OF MANUFACTURING THE SAME**

(30) Priority: 13.12.2019 KR 20190167071; 31.03.2020 KR 20200038840
(71) Applicant: Samsung Electronics Co., Ltd., Suwon-si 16677 (KR)
(72) Inventor: SHIN, Seonghwan, 16677 Gyeonggi-do (KR); JUNG, Sungsoo, 16677 Gyeonggi-do (KR); OH, Pilyong, 16677 Gyeonggi-do (KR); LEE, Kwangjae, 16677 Gyeonggi-do (KR); HAN, Jeongin, 16677 Gyeonggi-do (KR)
(74) Representative: Walaski, Jan Filip

(57) **Abstract**

A display module may include: (1) a substrate including a mounting surface on which a thin film transistor (TFT) layer is formed, a side surface, and a chamfer portion formed between the mounting surface and the side surface; (2) a plurality of inorganic light emitting diodes (LEDs) disposed on the TFT layer, each of the plurality of inorganic LEDs including a pair of electrodes electrically connected to the TFT layer and disposed to face the mounting surface, and a light emitting surface configured to emit light in a first direction opposite to a second direction that extends from the plurality of inorganic LEDs to the mounting surface of the substrate; and (3) a molding provided to cover the plurality of inorganic LEDs, the chamfer portion of the substrate, and the side surface of the substrate.

## Description

### CROSS-REFERENCE TO RELATED APPLICATION

This application is based on and claims priority to Korean Patent Applications No. 10-2019-0167071, filed on December 13, 2019 and No. 10-2020-0038840, filed on March 31, 2020 in the Korean Intellectual Property Office.

### BACKGROUND

### 1. Field

The disclosure relates to a display apparatus for displaying an image by coupling modules each having self-emissive inorganic light emitting diodes mounted on a substrate thereof.

### 2. Description of the Related Art

A display apparatus is a type of an output device that visually displays data information, such as characters and figures, images, and the like.

In general, for a display apparatus, a liquid crystal panel requiring a backlight, or an Organic Light-Emitting Diode (OLED) panel formed of an organic compound film that emits light by itself in response to an electric current have been mainly used. However, the liquid crystal panel has a slow response time and large power consumption, and requires a backlight due to limitation on emitting light by itself, having a difficulty in providing the display apparatus in a compact size. In contrast, the OLED panel does not require a backlight due to emitting light by itself, and thus achieves slim thickness, but the OLED panel is susceptible to a burn-in phenomenon in which when the same screen is displayed for a long time, a part of the screen remains even when the screen is switched due to the life of sub-pixels being ended.

Accordingly, in order to find a replacement for the LCD panel and the OED panel, research has been conducted on a micro light emitting diode (micro LED or µLED) panel that mounts an inorganic light emitting diode on a substrate and uses the inorganic light emitting diode itself as a pixel.

Micro light-emitting diode display panel (hereinafter, referred to as a micro LED panel) is one of flat panel display panels and includes a plurality of inorganic light-emitting diodes (inorganic LEDs) each having a size of 100 micrometers or less.

Such an LED panel is a self-emissive device but is not susceptible to OLED burn-in as an inorganic light-emitting device, and has excellent brightness, resolution, power consumption, and durability.

Compared to the LCD panels that require backlighting, micro LED display panels provide better contrast, response time, and energy efficiency. OLEDs and micro-LEDs (i.e., inorganic LEDs) are both energy efficient, but micro LEDs have excellent brightness, luminous efficiency, and lifespan compared to OLEDs.

In addition, the micro LEDs may achieve a substrate-level display modulation by arranging LEDs on a circuit board in units of pixels, and provide various resolutions and screen sizes of display according to the customer's order.

### SUMMARY

Example embodiments address at least the above problems and/or disadvantages and other disadvantages not described above. Also, the example embodiments are not required to overcome the disadvantages described above, and may not overcome any of the problems described above.

One or more example embodiments of the present disclosure provide a display apparatus and a method of manufacturing the same, and specifically, a display module suitable for a large sized display, a display apparatus having the same, and a method of manufacturing the same.

Additional aspects of the disclosure will be set forth in part in the description which follows and, in part, will be obvious from the description, or may be learned by practice of the disclosure.

According to an aspect of the disclosure, there is provided a display module including: (1) a substrate including a mounting surface on which a thin film transistor (TFT) layer is formed, a side surface, and a chamfer portion formed between the mounting surface and the side surface; (2) a plurality of inorganic light emitting diodes (LEDs) disposed on the TFT layer, each of the plurality of inorganic LEDs including: a pair of electrodes electrically connected to the TFT layer and disposed to face the mounting surface, and a light emitting surface configured to emit light in a first direction opposite to a second direction that extends from the plurality of inorganic LEDs to the mounting surface of the substrate; and a molding provided to cover the plurality of inorganic LEDs, the chamfer portion of the substrate, and the side surface of the substrate.

The mounting surface may include four edges, and one of the four edges may correspond to the side surface, and the molding may cover the four edges of the mounting surface.

The display module may further include a printed circuit board (PCB) configured to electrically control the plurality of inorganic LEDs, wherein the PCB may be arranged on a rear surface of the substrate that is disposed to be opposite to the mounting surface, and the molding may surround the mounting surface, the chamfer portion, and the side surface.

The display module may further include a cover arranged on an upper surface of the molding, wherein the molding may have a first surface area larger than a second surface area of the mounting surface of the substrate, and the cover may have a third surface area equal to or larger than the first surface area of the molding.

The display module may further include a cover arranged on an upper surface of the molding, wherein the cover may include a cover glass; and a circular polarization layer arranged in front of the cover glass and configured to circularly polarize light that is transmitted through the circular polarization layer.

The display module may further include a light absorbing pattern arranged between the molding and the cover glass, and a black matrix formed between the plurality of inorganic LEDs on the mounting surface, wherein the light absorbing pattern may be located at a position corresponding to a position of the black matrix in a third direction in which the mounting surface faces.

The display module of claim 6, wherein the light absorbing pattern may extend outside the side surface in a fourth direction perpendicular to the third direction in which the mounting surface faces.

The display module may further include a cover arranged on an upper surface of the molding, wherein the cover may include a first layer, and a second layer stacked on the first layer and located at a rear side of the first layer in the first direction.

The first layer may include at least one of an anti-glare layer provided to diffusely reflect an incident light or an anti-reflect layer provided to change a reflection direction of the incident light.

The second layer may include a material that lowers transmission of an incident light that is incident on the second layer and then is transmitted through the second layer.

The second layer may include a circular polarization layer.

The display module may further include a black matrix arranged between the plurality of inorganic LEDs.

Each of the plurality of inorganic LEDs may further include a bottom surface formed at a side opposite to the light emitting surface, wherein the pair of electrodes may be arranged on the bottom surface.

According to another aspect of the disclosure, there is provided a display apparatus including a display module array in which a plurality of display modules are arranged in a M X N matrix, wherein M and N may be natural numbers, and wherein each of the plurality of display modules may include: (1) a substrate including a mounting surface on which a thin film transistor (TFT) layer is formed, a side surface, and a chamfer portion formed between the mounting surface and the side surface; (2) a plurality of inorganic light emitting diodes (LEDs) disposed on the TFT layer, each of the plurality of inorganic LEDs including a pair of electrodes electrically connected to the TFT layer and disposed to face the mounting surface, and a light emitting surface configured to emit light in a first direction opposite to a second direction that extends from the plurality of inorganic LEDs to the mounting surface of the substrate the pair of electrodes are disposed; and a molding provided to cover the plurality of inorganic LEDs, the chamfer portion of the substrate, and the side surface of the substrate.

Each of the plurality of display modules may further include a printed circuit board (PCB) provided to drive the plurality of inorganic LEDs and disposed at a side opposite to the mounting surface, and a wiring connecting the plurality of inorganic LEDs to the PCB and extending along the side surface, wherein the molding is provided to cover the wiring extending on the side surface.

The mounting surface may include four edges, and one of the four edges may correspond to the side surface, and the molding may cover the four edges of the mounting surface.

The molding may include a first region located outside the mounting surface in a third direction perpendicular to the first direction and a second region located on the mounting surface, and the cover may include a first region located to correspond to the first region of the molding in the first direction and a second region located to correspond to the second region of the molding in the first direction.

The plurality of display modules may include a first display module and a second display module arranged adjacent to the first display module in the third direction. The plurality of inorganic LEDs of the first display module may include a first inorganic LED adjacent to the second display module and a second inorganic LED adjacent to the first inorganic LED in the third direction. The plurality of inorganic LEDs of the second display module may include a third inorganic LED adjacent to the first display module and a fourth inorganic LED adjacent to the third inorganic LED in the third direction. An interval between the first inorganic LED and the second inorganic LED may correspond to an interval between the first inorganic LED and the third inorganic LED.

A sum of a length between an end portion of the substrate of the first display module and the first LED in a fourth direction toward the second display module and a length of the first region of the molding in the fourth direction toward the second display module may correspond to half of the interval between the first inorganic LED and the second inorganic LED.

The cover may include a cover glass and a circular polarization layer arranged at an upper side of the cover glass in the first direction.

According to another aspect of the disclosure, there is provided a display apparatus including: (1) a front cover configured to protect the display apparatus from external force; (2) a substrate disposed to be opposite to the front cover; (3) a thin film transistor (TFT) layer disposed on the substrate, and between the substrate and the front cover; (4) a plurality of micro inorganic light emitting diodes (LEDs) disposed on the TFT layer, each of the plurality of micro inorganic LEDs including: at least one electrode that is connected to the TFT layer; and a light emitting surface configured to emit light in a direction toward the front cover; and (5) a molding disposed between the substrate and the front cover, to cover the micro inorganic LEDs and the substrate.

### BRIEF DESCRIPTION OF THE DRAWINGS

These and/or other aspects of the disclosure will become apparent and more readily appreciated from the following description of the embodiments, taken in conjunction with the accompanying drawings of which:
FIG. 1 is a view illustrating a display apparatus according to an embodiment of the disclosure;
FIG. 2 is an exploded view illustrating main components of the display apparatus shown in FIG. 1;
FIG. 3 is an enlarged cross-sectional view illustrating some components shown in FIG. 1;
FIG. 4 is a perspective view illustrating a display module of the display apparatus shown in FIG. 1;
FIG. 5 is a cross-sectional view illustrating some components of the display apparatus shown in FIG. 1;
FIG. 6 is an enlarged cross-sectional view illustrating other components shown in FIG. 5;
FIG. 7 is a cross-sectional view illustrating some components of the display apparatus shown in FIG. 1;
FIG. 8 is a flowchart showing a method of manufacturing a display apparatus according to an embodiment of the disclosure; and
FIG. 9 is an enlarged cross-sectional view illustrating some components of a display apparatus according to another embodiment of the disclosure.

### DETAILED DESCRIPTION

Example embodiments are described in greater detail below with reference to the accompanying drawings.

In the following description, like drawing reference numerals are used for like elements, even in different drawings. The matters defined in the description, such as detailed construction and elements, are provided to assist in a comprehensive understanding of the example embodiments. However, it is apparent that the example embodiments can be practiced without those specifically defined matters. Also, well-known functions or constructions are not described in detail since they would obscure the description with unnecessary detail.

In the following description, it is to be understood that the singular forms "a," "an," and "the" include plural references unless the context clearly dictates otherwise. In order to make the description of the disclosure clear, unrelated parts are not shown and, the sizes of components are exaggerated for clarity.

It will be further understood that the terms "include", "comprise" and/or "have" when used in this specification, specify the presence of stated features, integers, steps, operations, elements, and/or components, but do not preclude the presence or addition of one or more other features, integers, steps, operations, elements, components, and/or groups thereof.

In addition, the meaning of "identical" in the specification may include having similar properties or similarity within a certain range. In addition, the "identical" refers to "substantially identical". It should be understood that the meaning of "substantially identical" refers to a value that falls within an error range in manufacturing or a value having a difference within a range that does not have a significance with respect to a reference value.

Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, all of a, b, and c, or any variations of the aforementioned examples.

Hereinafter, embodiments according to the disclosure will be described in detail with reference to the accompanying drawings.

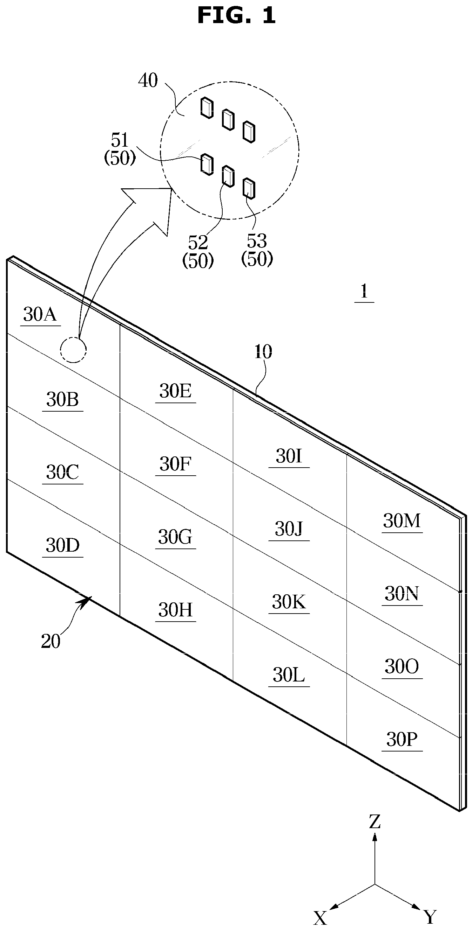

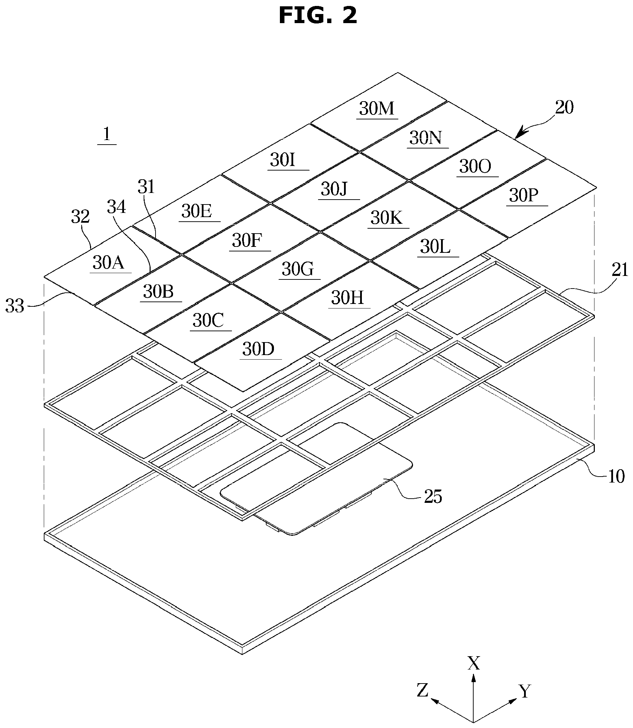

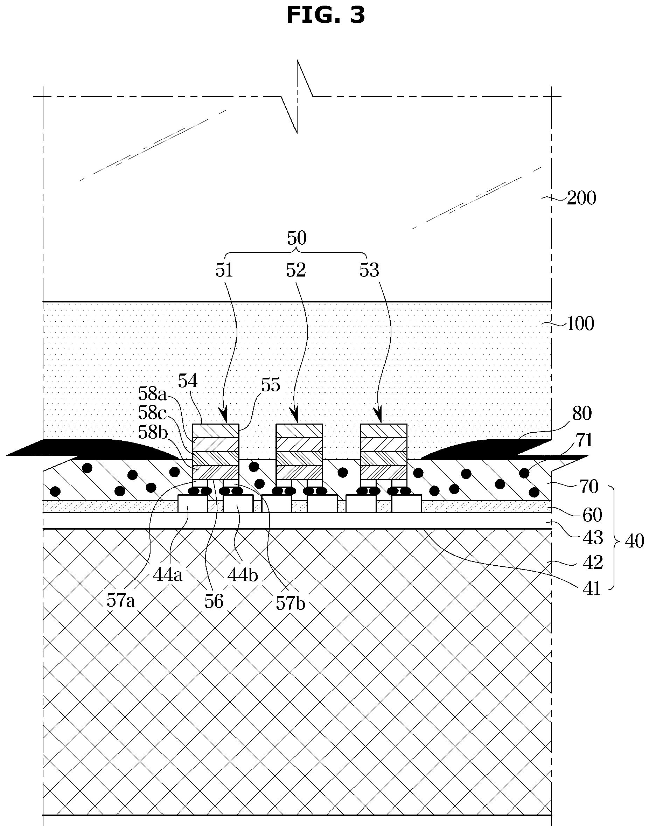

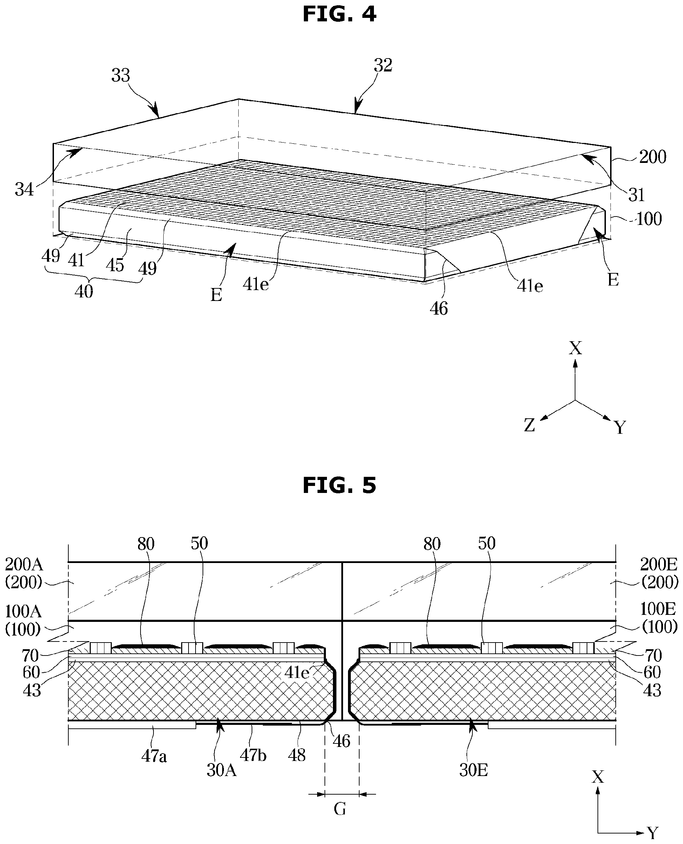

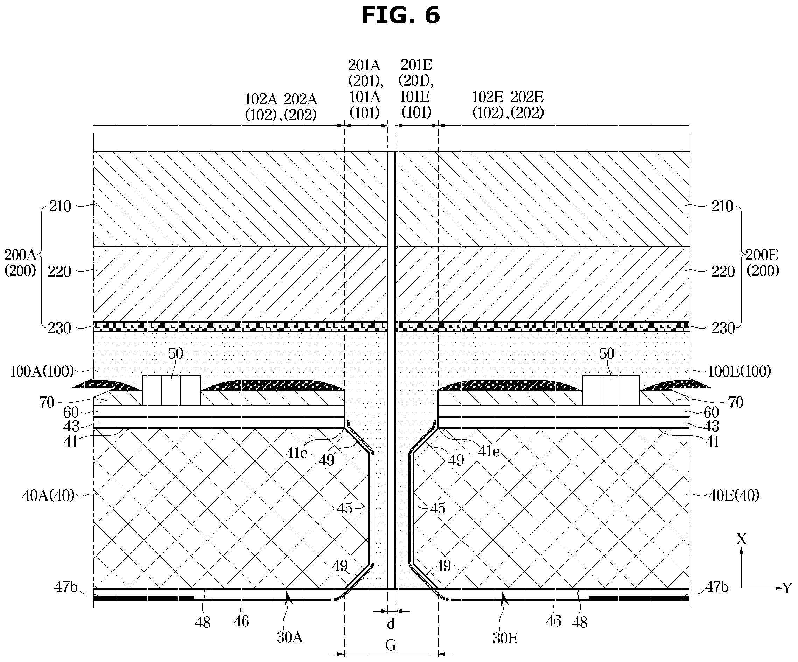

FIG. 1 is a view illustrating a display apparatus according to an embodiment of the disclosure, FIG. 2 is an exploded view illustrating main components of the display apparatus shown in FIG. 1, FIG. 3 is an enlarged cross-sectional view illustrating some components shown in FIG. 1, FIG. 4 is a perspective view illustrating a display module of the display apparatus shown in FIG. 1, FIG. 5 is a cross-sectional view illustrating some components of the display apparatus shown in FIG. 1, and FIG. 6 is an enlarged cross-sectional view illustrating other components shown in FIG. 5.

In the following description, components of a display apparatus 1 including a plurality of inorganic light emitting diodes 50 shown in the drawings are components in micro-units having a size of several µm to several hundreds of µm, and the sizes of some components (a plurality of inorganic light emitting diodes 50, a black matrix 80, etc.) shown in the drawings may be exaggerated for the sake of convenience of description.

The display apparatus 1 is a device that displays information, material, data, etc. as characters, figures, graphs, images, etc., and maybe implemented as a television (TV), a personal computer (PC), a mobile, a digital signage, etc.

According to the embodiment of the disclosure, referring to FIGS. 1 and 2, the display apparatus 1 includes a display panel 20 displaying an image, a power supply device configured to supply power to the display panel 20, a main board 25 controlling the overall operation of the display panel 20, a frame 21 supporting the display panel 20, and a rear cover 10 covering a rear surface of the frame 21.

The display panel 20 may include a plurality of display modules 30A to 30P, a driving board for driving each of the display modules 30A to 30P, and a Timing Controller (TCON) board generating a timing signal required for controlling each of the display modules 30A to 30P.

The rear cover 10 may support the display panel 20. The rear cover 10 may be installed on the floor through a stand, or may be installed on a wall through a hanger.

The plurality of display modules 30A to 30P may be arranged in upper and lower side directions and left and right side directions so as to be adjacent to each other. The plurality of display modules 30A to 30P may be arranged in an M ^{∗} N matrix form, wherein M and N are natural numbers. In the embodiment, the display modules 30A to 30P are provided as sixteen display modules 30A to 30P and are arranged in a 4 ^{∗} 4 matrix form, but there is no limitation on the number and arrangement method of the plurality of display modules 30A to 30P.

The plurality of display modules 30A to 30P may be installed on the frame 21. The plurality of display modules 30A to 30P may be installed on the frame 21 through various methods, such as magnetic force using a magnet or a mechanical fitting structure. The rear cover 10 is coupled to the rear of the frame 21, and the rear cover 10 may form the rear appearance of the display apparatus 1.

As described above, the display apparatus 1 according to the embodiment of the disclosure may implement a large screen by tiling the plurality of display modules 30A to 30P.

According to another embodiment, in the plurality of display modules 30A to 30P, each single display module may be applied to a display apparatus. That is, the display modules 30A to 30P may be individually installed on an electronic product or a machine part, such as a wearable device, a portable device, a handheld device, and other various displays that require various displays, or may be assembled in a matrix form as in the embodiment and used for a display apparatus, such as a monitor for a PC, a high-definition TV and signage, and an electronic display.

The plurality of display modules 30A to 30P may have the same configuration. Therefore, the description of any one display module described below may be equally applied to all other display modules.

One of the plurality of display modules 30A to 30P, for example, the first display module 30A may be formed in a quadrangle type. Alternatively, the first display module 30A maybe provided in a rectangular type or a square type.

Accordingly, the first display module 30A may include edges 31, 32, 33, and 34 formed in the upper and lower side direction and the left and right side directions with respect to a first direction X, which is the forward direction. The first direction X may be normal or perpendicular to a surface of the first display module 30A, and may be opposite to a direction that extends from the plurality of inorganic light emitting diodes 50 to the mounting surface 41.

Referring to FIG. 3, each of the plurality of display modules 30A to 30P may include a substrate 40 and a plurality of inorganic light emitting diodes 50 mounted on the substrate 40. The plurality of inorganic light emitting diodes 50 may be mounted on a mounting surface 41 of the substrate 40 facing in the first direction X.

The substrate 40 may be formed in a quadrangle type. As described above, the plurality of display modules 30A to 30P may be formed in a quadrangle shape, and the substrate 40 may be formed in a quadrangle shape to correspond to each display module.

The substrate 40 may be provided in a rectangular shape or a square shape.

Therefore, taking the first display module 30A as an example, the substrate 40 may include four edges E corresponding to the edges 31, 32, 33, and 34 of the first display module 30A formed in the upper and lower side directions and in the left and right side directions with respect to the first direction X, which is the forward direction (see FIG. 4).

The substrate 40 may include a base substrate 42 and a thin film transistor (TFT) layer 43 formed on the base substrate 42 to drive the inorganic light emitting diodes 50. The base substrate 42 may include a glass substrate. That is, the substrate 40 may include a chip on glass (COG) type substrate. The substrate 40 may include first and second pad electrodes 44a and 44b provided to electrically connect the inorganic light emitting diodes 50 to the TFT layer 43.

A TFT constituting the TFT layer 43 is not limited to a specific structure or type, and may be configured in various embodiments. That is, the TFT of the TFT layer 43 according to an embodiment of the disclosure may be implemented as a Low Temperature Poly Silicon (LTPS) TFT, an oxide TFT, a Si (poly silicon, or a-silicon) TFT, an organic TFT, a graphene TFT, or the like. The TFT layer 43 may entirely or partially cover the mounting surface 41 of the substrate 40.

In addition, when the base substrate 42 of the substrate 40 is formed of a silicon wafer, the TFT layer 43 may be replaced by a Complementary Metal-Oxide Semiconductor (CMOS) type transistor or an n-type or p-type MOSFET transistor.

The plurality of inorganic light emitting diodes 50 may include inorganic light emitting diodes formed of an inorganic material and having a width, a length, and a height, each of several µm to several tens of µm. The micro-inorganic light emitting diode may have a short side of 100 µm or less among the width, the length, and the height. That is, the inorganic light emitting diode 50 may be picked up from a sapphire or silicon wafer and transferred directly onto the substrate 40. The plurality of inorganic light emitting diodes 50 may be picked up and transported through an electrostatic method using an electrostatic head or a stamp method using an elastic polymer material, such as polydimethylsiloxane (PDMS) or silicon, as a head.

The plurality of inorganic light emitting diodes 50 is a light emitting structure including an n-type semiconductor 58a, an active layer 58c, a p-type semiconductor 58b, a first contact electrode 57a, and a second contact electrode 57b.

One of the first contact electrode 57a and the second contact electrode 57b is electrically connected to the n-type semiconductor 58a, and the other is provided to be electrically connected to the p-type semiconductor 58b.

The first contact electrode 57a and the second contact electrode 57b may be in the form of a flip chip so as to be disposed parallel with each other while facing in the same direction (a direction opposite to the light emission direction).

The inorganic light emitting diode 50 includes a light emitting surface 54 disposed to face in the first direction X when mounted on the mounting surface 41, a side surface 55, and a bottom surface 56 disposed at a side opposite to the light emitting surface 54, and the first contact electrode 57a and the second contact electrode 57b may be formed on the bottom surface 56.

That is, the contact electrodes 57a and 57b of the inorganic light emitting diode 50 may be disposed on a side opposite to the light emitting surface 54 so as to be disposed at a side opposite and facing away the light emission direction.

The contact electrodes 57a and 57b may be disposed to face the mounting surface 41, may be electrically connected to the TFT layer 43, and the light emitting surface 54 may be arranged to emit light in a direction opposite and facing away from the contact electrodes 57a and 57b are oriented.

Therefore, when light generated from the active layer 58c is emitted in the first direction X through the light emitting surface 54, the light may be emitted in the first direction X without interfering with the first contact electrode 57a or the second contact electrode 57b.

That is, the first direction X may be defined as a direction in which light is emitted from the light emitting surface 54.

The first contact electrode 57a and the second contact electrode 57b may be electrically connected to the first pad electrode 44a and the second pad electrode 44b formed at a side of the mounting surface 41 of the substrate 40, respectively.

As will be described below, the inorganic light emitting diode 50 may be directly connected to the pad electrodes 44a and 44b through a bonding configuration, such as an anisotropic conductive layer 70 or solder.

The anisotropic conductive layer 70 may be formed on the substrate 40 to mediate electrical bonding between the contact electrodes 57a and 57b and the pad electrodes 44a and 44b. The anisotropic conductive layer 70 may represent an anisotropic conductive adhesive attached on a protective film, and have a structure in which conductive balls 71 are scattered in an adhesive resin. The conductive balls 71 may be conductive spheres surrounded by a thin insulating film, and when the insulating film is broken by a pressure, electrical connection occurs between conductors.

The anisotropic conductive layer 70 may include an anisotropic conductive film (ACF) in the form of a film and an anisotropic conductive paste (ACP) in the form of a paste.

Therefore, when the plurality of inorganic light emitting diodes 50 are mounted on the substrate 40, a pressure applied to the anisotropic conductive layer 70 causes the insulating film of the conductive balls 71 to be broken, so that the contact electrode 57a and 57b of the inorganic light emitting diode 50 may be electrically connected to the pad electrodes 44a and 44b of the substrate 40.

In another example, the plurality of inorganic light emitting diodes 50 may be mounted on the substrate 40 through a solder instead of the anisotropic conductive layer 70. The inorganic light emitting diode 50 may be aligned on the substrate 40 first, and then the inorganic light emitting diode 50 may be subject to a reflow process to be bonded to the substrate 40.

The plurality of inorganic light emitting diodes 50 may include a red light emitting device 51, a green light emitting device 52, and a blue light emitting device 53, and the light emitting devices 50 may be mounted on the mounting surface 41 of the substrate 40 in a series of the red light emitting devices 51, the green light emitting devices 52, and the blue light emitting devices 53 as one unit. A series of the red light emitting devices 51, the green light emitting devices 52, and the blue light emitting devices 53 may form one pixel. In this case, the red light emitting device 51, the green light emitting device 52, and the blue light emitting device 53 may each form a sub-pixel.

The red light emitting device 51, the green light emitting device 52, and the blue light emitting device 53 may be arranged in a line at predetermined intervals as in the embodiment of the disclosure, or maybe arranged in a different shape, such as a triangular shape.

The substrate 40 may include a light absorbing layer 60 to improve the contrast by absorbing external light. The light absorbing layer 60 may be formed at a side of the mounting surface 41 of the substrate 40 as a whole. The light absorbing layer 60 may be formed between the TFT layer 43 and the anisotropic conductive layer 70.

The plurality of display modules 30A to 30P may further include a black matrix 80 formed between the plurality of inorganic light emitting diodes 50.

The black matrix 80 may perform a function of supplementing the light absorbing layer 60 entirely formed at a side of the mounting surface 41 of the substrate 40. That is, the black matrix 80 absorbs external light and allows the substrate 40 to appear black, thereby improving the contrast of the screen.

The black matrix 80 may have a black color.

In the embodiment, the black matrix 80 is formed to be disposed between pixels each formed by a series of the red light emitting devices 51, the green light emitting devices 52, and the blue light emitting devices 53. In another embodiment, the black matrix 80 may be formed at a higher precision and partition each of the light emitting devices 51, 52, and 53, which are sub-pixels.

The black matrix 80 may be formed in a grid shape having a horizontal pattern and a vertical pattern so as to be disposed between pixels.

The black matrix 80 may be formed by applying a light-absorbing ink on the anisotropic conductive layer 70 through an ink-jet process and curing the light-absorbing ink, or by coating a light-absorbing film on the anisotropic conductive layer 70.

That is, on the anisotropic conductive layer 70 formed entirely on the mounting surface 41, the black matrices 80 may be formed gaps between the plurality of inorganic light emitting diodes 50 in which the plurality of inorganic light emitting diodes 50 are not mounted.

The plurality of display modules 30A to 30P may include moldings 100 disposed on upper sides of the mounting surfaces 41 in the first direction X to cover the plurality of display modules 30A to 30P, and/or the mounting surfaces 41 of the plurality of display modules 30A to 30P, respectively.

Referring to FIGS. 4 and 5, the plurality of moldings 100 may be provided so as to be respectively formed on the upper sides of the plurality of display modules 30A to 30P in the first direction X.

Each of the plurality of display modules 30A to 30P may be assembled after a separate molding 100 is formed. That is, when taking the first display module 30A and the second display module 30E as an example among the plurality of display modules 30A to 30P, a first molding 100A may be formed on the mounting surface 41 of the first display module 30A, and a second molding 100E may be formed on the mounting surface 41 of the second display module 30E.

The molding 100 may cover the substrate 40 to protect the substrate 40 from external force or external moisture.

Each molding 100 may be formed of an optically transparent resin (e.g., Optical Clear Resin (OCR)). The OCR may be highly transparent with a transmittance of 90% or more.

The OCRs may improve visibility and image quality by increasing transmittance through low-reflection properties. That is, in a structure having an air gap, light loss occurs due to a difference in refractive index between a film layer and an air layer, but in a structure using an OCR, the difference in refractive index decreases, thereby reducing light loss and consequently improving visibility and image quality.

That is, the OCR may improve image quality as well as protecting the substrate 40.

The molding 100 may have a predetermined height or larger in the first direction X in which the mounting surface 41 or the light emitting surface 54 faces.

This is to sufficiently fill a gap that may be formed between the molding100 and the plurality of inorganic light emitting diodes 50 when the molding100 is formed on the substrate 40.

In detail, the plurality of inorganic light emitting diodes 50 mounted on the mounting surface 41 are disposed to protrude than the mounting surface 41 in the first direction X, and thus an uneven portion may be formed on the mounting surface 41 due to the plurality of inorganic light emitting diodes 50.

When the molding 100 is formed on the mounting surface 41, a void region may be formed between the mounting surface 41 and the molding 100 due to the uneven portion formed on the mounting surface 41. In order to fill the uneven portion on the mounting surface 41 formed by the plurality of inorganic light emitting diodes 50, the molding 100 needs to have a height at least several ten fold or several hundred fold greater than the height of the plurality of protruding inorganic light emitting diodes 50. That is, the molding 100 is formed on the mounting surface 41 by being compression-hardened on the mounting surface 41, and in a process of the molding being cured, a void region may be formed between the mounting surface 41 and the molding100 due to the uneven portion, which may cause air bubbles to be formed.

However, when the molding100 is formed to a certain height, the molding100 may be formed inside the uneven portion formed on the mounting surface 41 during the compression hardening, so that the molding100 may be completely formed on the mounting surface 41 without an empty space between the mounting surface 41 and the molding100.

The plurality of display modules 30A to 30P may include front covers 200 disposed at the foremost sides of the plurality of display modules 30A to 30P in the first direction X, respectively.

The front cover 200 may be provided in plural so as to be disposed on each of the plurality of display modules 30A to 30P. Each of the front covers 200 may be bonded to an upper side of a corresponding one of the moldings 100 of the plurality of display modules 30A to 30P in the first direction.

The front cover 200 may protect the substrate 40 from external force. As will be described below, the front cover 200 may reduce the revelation of a seam formed by a gap G formed between the plurality of display modules 30A to 30P, and improve color deviation between the plurality of display modules 30A to 30P.

The plurality of display modules 30A to 30P may be assembled after separate front covers 200 are bonded to respective moldings 100. That is, when taking the first display module 30A and the second display module 30E among the plurality of display modules 30A to 30P as an example, a first front cover 200A may be formed on the first molding100A of the first display module 30A and a second front cover 200E may be formed on the second molding100E of the second display module 30E.

Hereinafter, the molding100 and the front cover 200 will be described in detail.

Since the plurality of display modules 30A to 30P are formed identical to each other, the plurality of display modules 30A to 30P will be described in relation to the first display module 30A.

That is, in order to avoid redundant descriptions, the configuration of the plurality of display modules 30A to 30P will be described in relation to the display module 30, the substrate 40, the molding100, and the front cover 200 as an example.

In addition, the first display module 30A and a second display module 30E disposed adjacent to the first display module 30A in a second direction Y among the plurality of display modules 30A to 30P will be described as needed.

In addition, since the plurality of display modules 30A to 30P is formed identical to each other, the moldings 100 and the front covers 200 formed on the plurality of display modules 30A to 30P will be described in relation to the first molding 100A and the first front cover 200A of the first display module 30A and the second molding 100E and the second front cover 200E of the second display module 30E as an example.

One of a plurality of display manufacturing processes that implement a display panel using a display module is configured in a way to arrange a plurality of display modules adjacent to each other, form a single molding on the entire area of mounting surfaces of the plurality of display modules and gaps between the plurality of display modules, and form a light absorbing pattern on the molding, and collectively form a single front cover on the light absorbing pattern.

Alternatively, another processing method is configured in a way to form a light absorbing pattern on a single front cover, and tile a plurality of display modules to match with the light absorbing pattern to arrange the light absorbing pattern between gaps between the plurality of display modules.

Alternatively, another processing method is configured in a way to form a light absorbing pattern configuration in advance when forming a light absorbing pattern on a molding or a front cover before tiling a plurality of display modules. Unlike the above described processing methods, the display apparatus 1 according to the embodiment of the disclosure is manufactured by forming the molding 100 and the front cover 200 on each of the plurality of display modules 30A to 30P before tiling the plurality of display modules 30A to 30P. In addition, in order to absorb light reflected from the gaps G between the plurality of display modules 30A to 30P, the molding 1000 and the front cover 200 of each of the plurality of display modules 30A to 30P may be formed to extend outside the substrate 40 of each of the plurality of display modules 30A to 30P.

The gap G formed between the plurality of display modules 30A to 30P represents a gap between one of the side surfaces of the display modules 30A to 30P and another one of the side surface of the display modules 30A to 30P adjacent to the one side surface in the second direction Y or the third direction Z.

However, the side surfaces of the display modules 30A to 30P do not refer to side surfaces 45 of the substrates 40, but refer to edges 41e of the mounting surfaces 41 of the display modules 30A to 30P.

Substantially, a gap between the display modules 30A to 30P may be formed between the side surfaces 45 of the substrates 40 of the display modules 30A to 30P, but since the gap G according to the embodiment of the disclosure refers to a non-display area that may be formed between the display modules 30A to 30P, the gap G formed between the plurality of display modules 30A to 30P should be understood as a gap from one of the edges 41e of the mounting surfaces 41 of the substrates 40 of the display modules 30A to 30P to another one of the edges 41e of the mounting surfaces 41 of the substrates 40 of the display modules 30A to 30P adjacent to the one edge 41e.

Therefore, the gap G formed between the plurality of display modules 30A to 30P refers to a gap formed between one of the edges 41e of the mounting surfaces 41 of the display modules 30A to 30P and another one of the edges 41e of the mounting surfaces 41 of the display modules 30A to 30P adjacent to the one edge 41e in the second direction Y or the third direction Z.

Accordingly, as will be described below, in the gaps G formed between the plurality of display modules 30A to 30P, chamfer portions 49 and the side surfaces 45 of the substrates 40 of the display modules 30A to 30P may be disposed.

Accordingly, when the plurality of display modules 30A to 30P are tiled, the molding 100 and the front cover 200 extending from each of the display modules 30A to 30P are arranged in the gap G between the plurality of display modules 30A to 30P to absorb light transmitted to the gap G or light reflected from the gap G, thereby minimizing the perception of a seam.

Referring to FIG. 6, the molding 100 and the front cover 200 extend to the outside of the substrate 40 in the second direction Y.

The substrate 40 may include the mounting surface 41, a rear surface 48 formed parallel to the mounting surface 41, and the side surfaces 45 disposed between the mounting surface 41 and the rear surface 48.

The substrate 40 may include the chamfer portion 49 formed between the mounting surface 41 and the side surface 45 and between the rear surface 48 and the side surface 45.

The chamfer portion 49 may prevent each of the substrates from colliding and being damaged when the plurality of display modules 30A to 30P are arranged.

The molding 100 may surround and cover the substrate 40. For example, the molding may cover the mounting surface 41 of the substrate 40 in the first direction X.

In addition, the molding 100 may cover not only the mounting surface 41 of the substrate 40 but also the side surface 45 facing in the second direction Y perpendicular to the first direction X and the chamfer portion 49.

The embodiment of the disclosure is described in relation to one edge E of the substrate 40 corresponding to the right edge 31 of the first display module 30A, but as shown in FIG. 4, the chamfer portions 49 and the side surfaces 45 may be formed on the other edges E of the substrate 40 corresponding to the other edges 32, 33, and 34.

That is, the chamfer portion 49 and the side surface 45 may be arranged on each of the four edges E of the substrate 40. In addition, the molding 100 may cover the side surfaces 45 and the chamfer portions 49 formed on both side edges E of the substrate 40 in the second direction Y, and cover the side surfaces 45 and the chamfer portions 49 formed on both side edges E of the substrate 40 in the third direction Z (see FIG. 4).

Accordingly, the molding 100 may protect the plurality of inorganic light emitting diodes 50 mounted on the mounting surface 41 from external force while protecting the side surfaces 45 of the substrate 40 from external force.

Additionally, the molding 100 may protect the substrate 40 from external moisture.

The first display module 30A may include a printed circuit board (PCB) 47a provided to electrically control the plurality of inorganic light emitting diodes 50 mounted on the mounting surface 41 (see FIG. 5)

The PCB 47a may supply power to the plurality of inorganic light emitting diodes 50 or transmit electrical signals to the plurality of inorganic light emitting diodes 50 to control respective driving of the plurality of inorganic light emitting diodes 50.

The PCB 47a may be disposed on the rear surface 48 of the substrate 40 in the first direction X.

The substrate 40 may include a wiring 46 that electrically connects the PCB 47a to the plurality of inorganic light emitting diodes 50. The wiring 46 may be provided in the form of a thin film.

The wiring 46 may connect the TFT layer 43 formed on the mounting surface 41 to the PCB 47a. In addition, a flexible circuit board 47b may be disposed between the wiring 46 and the PCB 47a to electrically connect the wiring 46 to the PCB 47a.

The flexible circuit board 47b may be disposed on the rear surface 48 of the substrate 40 together with the PCB 47a.

The TFT layer 43, the wiring 46, the flexible circuit board 47b, and the PCB 47a may be electrically connected in the order.

The wiring 46 has one end connected to a contact pad of the TFT layer 43 disposed on the side of the edge 41e of the mounting surface 41e, so that the TFT layer 43 is electrically connected to the wiring 46.

In addition, the wiring 46 has the other end connected to the flexible circuit board 47b so that the wiring 46 is electrically connected to the flexible circuit board 57b.

That is, the contact pad of the TFT layer 43 and a part of the wiring 46 may be disposed on the mounting surface 41 of the substrate 40, and the wiring 46 may be disposed on the side surface 45 of the substrate 40, and the PCB 47a, the flexible circuit board 47b, and at least a part of the wiring 46 may be disposed on the rear surface 480 of the substrate 40.

As described above, since the TFT layer 43 is formed on the mounting surface 41 of the substrate 40, and the PCB 47a is disposed on the rear surface 48 of the substrate 40 opposite to the mounting surface 41, the wiring 46 may formed to extend along the chamfer portion 49 and the side surface 45 of the substrate 40 to connect the TFT layer 43 and the PCB 47a to each other.

The molding 100 may cover the mounting surface 41, the chamfer portion 49, and the side surface 45 of the substrate 40. Additionally, the molding 100 may cover the wiring 46 extending along the chamfer portion 49 and the side surface 45 while covering the chamfer portion 49 and the side surface 45.

That is, the molding 100 may be provided such that a portion of the molding 100 extends outside the mounting surface 41 in the second direction Y covers the chamfer portion 49, the side surface 45, and the wiring 46.

Accordingly, the molding 100 may cover at least a portion of the wiring 46 in addition to the substrate 40 to thereby protect the substrate 40 and the wiring 46 from external force.

According to the embodiment of the disclosure, the wiring 46 may extend along the side surface 45 of the substrate 40 in the second direction Y to reach the rear surface 48 of the substrate 40. Accordingly, the wiring 46 of the first display module 30A may be disposed adjacent to the second display module 30E that is adjacent to the first display module 30A in the second direction Y.

However, the disclosure is not limited thereto, and the wiring 46 may extend along the side surface 45 of the substrate 40 in the third direction Z perpendicular to the first and second directions X and Y to reach the rear surface 48 of the substrate 40. In this case, the wiring 46 of the first display module 30A may be disposed adjacent to a third display module 30B that is adjacent to the first display module 30A in the third direction Z.

That is, according to the embodiment of the disclosure, the wiring 46 may extend along a side of one edge E of the substrate 40 corresponding to the right edge 31 of the first display module 30A. However, the disclosure is not limited thereto, and the wiring 46 may extend along edges E of the substrate 40 corresponding to at least two of the four edges 31, 32, 33, and 34 of the first display module 30A.

According to the embodiment of the disclosure, the wiring 46 may extend along the side surfaces 45 formed on a pair of edges E of the substrate 40 corresponding to the right edge 31 and the left edge 33 to reach the rear surface 48 of the substrate 40.

However, the disclosure is not limited thereto, and the wiring 46 may not extend along the edge E of the substrate 40 corresponding to the right edge 31 but may extend along the edge E of the substrate 40 corresponding to the upper edge 32 or the lower edge 34.

At a side of an edge E of the substrate 40 on which the wiring 46 is disposed, such as the edge E of the substrate 40 corresponding to the right edge 31 among the four edges 31, 32, 33, and 34, the molding 100 may cover all the chamfer portion 49, the side surface 45, and the wiring 46, but at a side of an edge E of the substrate 40 on which the wiring 46 is not disposed, the molding 100 may cover only the chamfer portion 49 and the side surface 45.

The front cover 200 may include a first layer 210 disposed at the outermost side of the display module 30 in the first direction X and a second layer 220 disposed behind the first layer 220. The first and second layers 210 and 220 may be stacked one on top of the other in the first direction X.

The front cover 200 may include an adhesive layer 230 provided so that the first layer 210 and the second layer 220 are attached to an upper surface of the molding 100 in the first direction X. The adhesive layer 230 may be disposed at the rearmost side of the front cover 200 in the first direction X.

However, the disclosure is not limited thereto, and the adhesive layer 230 maybe provided as a component of the molding 100 that is arranged on an upper surface of the molding 100 in the first direction X such that the front cover 200 is attached to the molding 100.

The adhesive layer 230 may be formed of a transparent material so that light may be easily transmitted therethrough. In an embodiment, the adhesive layer 230 maybe in a highly transparent state having a transmittance of 90% or more, such as an optically transparent resin (OCR).

Accordingly, external light may sequentially pass through the first layer 210, the second layer 220, and the adhesive layer 230 and then transmit through the molding 100 to reach the substrate 40 and the gap G.

On the contrary, light reflected from the substrate 40 and the gap G may transmit through the molding 100 and then sequentially pass through the adhesive layer 230, the second layer 220, and the first layer 210 to the outside of the display panel 20.

The first layer 210 may be provided as an anti-glare layer 210. That is, the first layer 210 may be formed of a material that diffusely reflects light incident from the outside, or may include particles that diffusely reflects light incident from the outside.

However, the disclosure is not limited thereto, and the first layer 210 maybe formed as a layer having a different property or material, or having a different function, which will be described below. In the following description, the first layer 210 will be illustrated as an anti-glare layer 210 for the sake of convenience in description.

The anti-glare layer 210 may diffusely reflects the light incident from the outside so as to prevent the externally incident light from being regularly reflected and dazzling the user.

As light incident from the outside is diffusely reflected, a glare phenomenon may be reduced and the contrast of a screen displayed on the display panel 20 maybe improved.

The second layer 220 may be provided as a light transmittance control layer 220. That is, the second layer 220 may be formed of a material that passes only a part of light incident from the outside or may include particles having a low light transmittance.

However, the disclosure is not limited thereto, and the second layer 220 maybe formed as a layer having a different property or material, or having a different function, which will be described below. In the following description, the second layer 210 will be illustrated as a light transmittance control layer 210 for the sake of convenience in description.

The light transmittance control layer 220 may reduce the transmittance of incident external light or the transmittance of external light reflected from the substrate 40 and the gap G.

The light transmittance control layer 220 according to the embodiment of the disclosure includes a material of a component that lowers the transmittance of light so as to allow at least a part of light to be transmitted to the substrate 40 therethrough or absorb at least a part of light reflected from the substrate 40 and proceeding in the first direction X.

The light transmittance control layer 220 may have a transparency lower than that of the molding 100 in order to lower the transmittance of light. When a plurality of substrates are produced, some substrates may have different colors due to process errors during the production. Accordingly, substrates having different unique colors may be tiled to form a single display panel.

As described above, the light transmittance control layer 220 according to the embodiment of the disclosure absorbs at least a part of light reflected from the substrate 40 and transmitted to the outside, thereby increasing the sense of unity of the screen of the display panel 20.

That is, the light transmittance control layer 220 may reduce the color deviation of each display module 30A to 30P occurring due to process errors of the display module 30A to 30P by lowering the external light transmittance.

The anti-glare layer 210 may prevent external light incident onto the display panel 20 from being transmitted to the substrate 40, and the light transmittance control layer 220 may absorb a part of light incident onto the display panel 20 from the outside or absorb a part of external light reflected from the substrate 40 and transmitted to the outside of the display panel 20 to improve the contrast of a screen displayed on the display panel.

That is, the front cover 200 may be disposed in front of the substrate 40 in the first direction X to improve the contrast that may be degraded by external light on the screen displayed on the display panel 20.

As described above, in the case of the display module 30 according to the embodiment of the disclosure, the front cover 200 may extend outside of the substrate 40 in the second direction Y.

Accordingly, a part of the light introduced into the gap G formed between the plurality of display modules 30A to 30P may be blocked by at least a part of the anti-glare layer 210 disposed in the gap G, and at least a part of external light introduced into the gap G or reflected in the gap G may be absorbed by the light transmittance control layer 220 disposed in the gap G and prevented from being transmitted to the outside. Accordingly, the revelation of a seam formed in the gap G may be reduced, and the sense of unity of the screen displayed on the display panel 20 maybe improved as the revelation of the seam decreases.

In detail, the molding 100 includes a first region 101 disposed outside the mounting surface 41 in the second direction Y or disposed in the gap G and a second region 102 disposed on the mounting surface 41.

The first region 101 of the molding 100 is a region of the molding 100 formed to cover the side surface 45 of the substrate 40.

The first region 101 and the second region 102 of the molding 100 may be divided by an edge 41e of the mounting surface 41. That is, the region disposed outside the mounting surface 41 with respect to the edge 41e of the mounting surface 41 is the first region 101 and the region disposed on the mounting surface 41 is the second region 102.

The molding 100 may surround the mounting surface 41 of the substrate 40 and the four side surfaces 45 of the substrate 40 corresponding to the four edges of the display module 30(see FIG. 4).

That is, the molding 100 may surround all the side surfaces 45 of the substrate 40. Accordingly, the molding 100 may include two first regions 101 in the second direction Y and two first regions 101 in the third direction Z.

Accordingly, all four side surfaces 45 of the substrate 40 may be protected from external force by the molding 100, and the wiring 46 extending along at least one of the four side surfaces 45 maybe protected from external force.

In addition, the revelation of the seam that may occur between the four side surfaces 45 and the display modules 30B and 30E adjacent to the side surfaces 45 may be reduced. Reducing of the revelation of the deliberation will be described in detail below.

Hereinafter, only the first region 101 covering the side surface 45 of the substrate 40 corresponding to the right edge 31 of the first display module 30A will be described in order to avoid redundant descriptions.

The front cover 200 may include a first region 201 disposed outside the mounting surface 41 in the second direction Y or in the gap G to correspond to the first region 101 of the molding 100 in the first direction X and a second region 202 disposed on the mounting surface 41 to correspond to the second region 102 of the molding 100 in the first direction X.

The first regions 101 and 201 of the molding 100 and the front cover 200 and the second regions 102 and 202 of the molding 100 and the front cover 200 may be divided by a gap G in the second direction Y.

The first region 201 of the front cover 200 is disposed in the gap G, and the first region 101 of the molding 100 supporting the first region 201 of the front cover 200 is disposed in the gap G. Accordingly, external light directed to the gap G may be blocked by the first region 201 of the front cover 200, or light reflected from the gap G and then directed to the outside is blocked by the first region 201 of the front cover 200 so that the revelation of a seam, which may be formed by the gap G as a boundary between the plurality of display modules 30A to 30P, is reduced and the sense of unity of the display panel 20 is improved.

As the first region 101 of the molding 100 is disposed in the gap G, the first region 201 of the front cover 200 may be stably supported. In addition, the first region 101 of the molding 100 covers the chamfer portion 49, the side surface 45, and the wiring 46 of the substrate 40 as described above, thereby protecting the mounting surface 41, the chamfer portion 49, the side surface 45, and the wiring 46 of the substrate 40 from the external force.

That is, when the molding 100 only includes the second region 102 without the first region 101, the side surface 45 and the wiring 46 of the substrate 40 may not be protected, and the first region 201 of the front cover 200 is not easily supported, so that the reliability of the display module 30 may be deteriorated.

As described above, the molding 100 and the front cover 200 may extend outside the mounting surface 41 not only in the second direction Y but also in a direction opposite to the second direction Y.

In addition, the molding 100 and the front cover 200 may extend outside the mounting surface 41 also in the third direction Z perpendicular to each of the first direction X and the second direction Y. That is, in an embodiment, the molding 100 and the front cover 200 may extend outside the four edges 41e of the mounting surface 41 (see FIG. 4).

Taking the first display module 30A and the second display module 30E as an example, the first region 101A of the first molding 100A and the first region 201A of the first front cover 200A extending from the first display module 30A may be disposed in the gap G formed between the first display module 30A and the second display module 30E.

The gap G may be defined as an interval between the edge 41e of the mounting surface 41 of the first display module 30A and the edge 41e of the mounting surface 41 of the second display module 30E in the second direction Y.

Accordingly, the side surfaces 45, the chamfer portions 49, and the wirings 46 of the first and second display modules 30A and 30E may be disposed in the gap G.

The second region 102A of the first molding 100A and the second region 202A of the first front cover 200A may be disposed on the mounting surface 41 of the first display module 30A.

The first region 101E of the second molding 100E and the first region 201E of the second front cover 200E extending from the second display module 30E may be disposed in the gap G formed between the first display module 30A and the second display module 30E, and the second region 102E of the second molding 100E and the second region 202E of the second front cover 200E may be disposed on the mounting surface 41 of the second display module 30E.

That is, in the gap G formed between the first display module 30A and the second display module 30E, the first regions 101A and 201A of the first molding 100A and the first front cover 200A are arranged parallel with the first regions 101E and 201E of the second molding 100E and the second front cover 200E in the second direction Y.

The first regions 101A, 201A, 101E, and 201E of the first and second moldings 100A and 100E and the first and second front covers 200A and 200E may each extend in the second direction Y or in a direction opposite to the second direction Y by a length less than half of the gap G.

Accordingly, when the first regions 101A and 201A of the first molding 100A and the first front cover 200A are arranged parallel with the first regions 101E and 201E of the second molding 100E and the second front cover 200E in the second direction Y, the size of the first regions 101A and 201A and the size of the first region 101E or 201E are set such that a value obtained by adding the length of the first region 101A or 201A of the first molding 100A or the first front cover 200A to the length of the first region 101E or 201E of the second molding 100E or the second front cover 200E in the second direction Y may be provided equal to or smaller than the length of the gap G in the second direction Y.

According to the embodiment of the disclosure, when the first regions 101A and 201A of the first molding 100A and the first front cover 200A are arranged parallel with the first regions 101E and 201E of the second molding 100E and the second front cover 200E in the second direction Y, a predetermined distance d may exist between the first regions 101A and 201A of the first molding 100A and the first front cover 200A and the first regions 101E and 201E of the second molding 100E and the second front cover 200E in the second direction Y.

However, the disclosure is not limited thereto, and the first display module 30A and the second display module 30E may be tiled without having the first regions 101A and 201A of the first molding 100A and the first front cover 200A spaced apart the first regions 101E and 201E of the second molding 100E and the second front cover 200E in the second direction Y. However, a predetermined distance d may exist between the first regions 101A and 201A of the first molding 100A and the first front cover 200A and the first regions 101E and 201E of the second molding 100E and the second front cover 200E in the second direction Y. However, for the assembly performance, in an embodiment, the first regions 101A and 201A of the first molding 100A and the first front cover 200A may be spaced apart from the first regions 101E and 201E of the second molding 100E and the second front cover 200E in the second direction Y by a predetermined distance d.

As described above, in the gap G between the first display module 30A and the second display module 30E, the first regions 101A and 201A of the first molding 100A and the first front cover 200A and the first regions 101E and 201E of the second molding 100E and the second front cover 200E may be arranged.

External light is sequentially transmitted through the first regions 201A and 201E of the first and second front covers 200A and 200E and then through the first regions 101A and 101E of the first and second moldings 100A and 100E, by which the external light is diffusely reflected to the outside or is partially absorbed by the first regions 201A, 201E of the first and second front covers 200A and 200E so that the amount of the external light reaching the gap G is reduced and the revelation of the boundary between the first display module 30A and the second display module 30E due to the gap G may be reduced.

In addition, light reflected from the gap G and directed to the outside of the display panel 20 is sequentially transmitted through the first regions 101A and 101E of the first and second moldings 100A and 100E and then through the first regions 201A and 201E of the first and second front covers 200A and 200E, by which the light is diffusely reflected outside of the display panel 20 or partially absorbed by the first regions 201A and 201E of the first and second front covers 200A and 200E and the amount of the light transmitted to the outside of the display panel 20 is reduced and the revelation of the boundary between the first display module 30A and the second display module 30E due to the gap G may be reduced.

That is, the first region 101 of the molding 100 and the first region 201 of the front cover 200 may allow the amount of external light introduced into the gap G formed between the plurality of display modules 30A to 30P while absorbing at least part of external light reflected from the gap G, so that the sense of unity of the screen of the display panel 20 may be improved.

Additionally, even when the substrate 40A of the first display module 30A and the substrate 40E of the second display module 30E have different colors, when each of the substrates 40A and 40E is displayed to the outside by reflection of external light, at least a part of the reflected light is absorbed by a corresponding one of the first and second front covers 200A and 200E, so that the unique color of each of the substrates 40A and 40E is not perceived to the outside, so that the sense of unity of the screen may be improved.

That is, the molding 100 and the front cover 200 reduce the revelation of the seam that may occur in the gap G between the plurality of display modules 30A to 30P while reducing the color deviation of the plurality of display modules 30A to 30P as described above, thereby improving the sense of unity of the screen of the display panel 20.

In an embodiment, end portions of the molding 100 and the front cover 200 in the second direction Y may be provided parallel to a direction corresponding to the first direction X. With such a configuration, when the plurality of display modules 30A to 30P are tiled, a gap between each of the display modules 30A to 30P may be minimized.

In addition, when the end portions of the molding 100 and the front cover 200 in the second direction Y are provided at an angle with respect to the first direction X, and the plurality of display modules 30A to 30P are tiled, the molding 100 or the front cover 200 may fail to be arranged in the gap G formed between the plurality of display modules 30A to 30P.

As light emitted from the plurality of display modules 30A to 30P passes through the molding 100 and the front cover 200, part of the light is reflected inside the molding 100 and the front cover 200 to move in a substantially second direction Y, which may cause a light leakage phenomenon in which light is transmitted through the end portions of the molding 100 and the front cover 200 in the second direction Y.

In this case, since the end portions of the molding 100 and the front cover 200 in the second direction Y are arranged in the gap G formed between the plurality of display modules 30A to 30P, when part of the light is transmitted to the outside of the display panel 20 at the gap G, the revelation of the seam perceived from the gap G may be increased.

However, when the end portions of the molding 100 and the front cover 200 of each of the display modules 30A to 30P in the second direction Y are formed to be parallel in the direction corresponding to the first direction X, the gap between the molding 100 and the front cover 200 of one of the display modules 30A to 30P and the molding 100 and the front cover 200 of another one of the display modules 30A to 30P adjacent to the one display module maybe minimized.

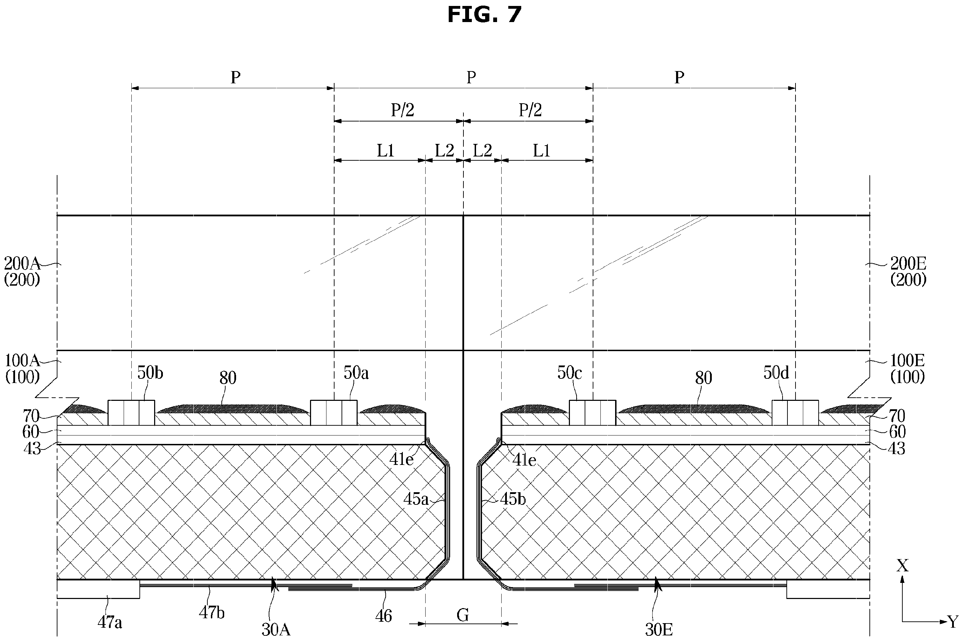

Accordingly, light moving inside the molding 100 and the front cover 200 of each of the display modules 30A to 30P in the second direction Y is not transmitted to the outside of the end portions of the molding 100 and the front cover 200 thereof in the second direction Y (or outside of the gap G), but is introduced into the molding 100 and the front covers 200 of an adjacent one display modules 30A to 30P, thereby reducing the revelation of the seam that may be perceived in the gap G. Hereinafter, a positional technical feature between the first display module 30A and the second display module 30E of the display apparatus 1 according to the embodiment of the disclosure will be additionally described with reference to FIG. 7. As described above, the first display module 30A and the second display module 30E are taken as an example of the plurality of display modules 30A to 30P, and thus the positional technical feature may be applied to all of the plurality of display modules 30A to 30P.

FIG. 7 is a cross-sectional view illustrating some components of the display apparatus shown in FIG. 1.

The plurality of inorganic light emitting diodes 50 mounted on the plurality of display modules 30A to 30P may be disposed at regular intervals. When some of the plurality of inorganic light emitting diodes 50 are arranged at different intervals, a part of the entire display image of the display panel 20 may be distorted.

When the interval between the plurality of inorganic light emitting diodes 50 mounted on each of the display module 30A to 30P is referred to as a pitch p, the plurality of inorganic light emitting diodes 50 mounted on each of the display module 30A to 30P may have the same pitch p.

In addition, with regard to one display module (the first display module 30A) and another display module (the second display module 30E) adjacent to the one display module 30A among the plurality of display modules 30A to 30P, the interval between an inorganic light emitting diode 50 on the one display module 30A adjacent to the other display module 30E and an inorganic light emitting diode 50 on the other display module 30E adjacent to the one display module 30A maybe provided with the same pitch p.

This is to prevent the screen of the display panel 20 from being distorted even at the boundaries between the display modules 30A to 30P.

The above configuration may be applied not only to the first and second display modules 30A and 30E, which will be described below, but also to other display modules adjacent to each other in the second direction Y or the third direction Z among the plurality of display modules 30A-30P.

The plurality of inorganic light emitting diodes 50 mounted on the first display module 30A and the second display module 30E may be disposed at the same pitch p.

The interval between a first inorganic light emitting diode 50a and a second inorganic light emitting diode 50b mounted on the first display module 30A and the interval between a third inorganic light emitting diode 50c and a fourth inorganic light emitting diode 50d mounted on the second display module 30E may have the same pitch p.

In addition, the interval between the inorganic light emitting diode 50a among the plurality of inorganic light emitting diodes 50 mounted on the first display module 30A that is closest to the side surface 45a of the substrate 40 of the first display module 30A adjacent to the second display module 30E in the second direction Y and the inorganic light emitting diode 50b among the plurality of inorganic light emitting diodes 50 mounted on the second display module 30E that is closest to the side surface 45a of the substrate 40 of the second display module 30E adjacent to the first display module 30A in the second direction Y may be equal to the pitch p.

That is, the interval between the first inorganic light emitting diode 50a on the first display module 30A adjacent to the second display module 30E in the second direction Y and the third inorganic light emitting diode 50c on the second display module 30E adjacent to the first display module 30A in the second direction Y may also be provided as the pitch p.

In this way, in order to provide the interval between the first inorganic light emitting diode 50a and the third inorganic light emitting diode 50c as the pitch p, the sum of a length L1 between the first inorganic light emitting diode 50a and the edge 41e of the mounting surface 41 of the substrate 40 in the second direction Y and a length L2 of the first region 101A or 201A of the molding 100A or the front cover 200A in the second direction Y may be provided to as half of the pitch p.

In addition, the sum of a length L1 between the third inorganic light emitting diode 50c and the edge 41e of the mounting surface 41 of the substrate 40 in the second direction Y and a length L2 of the first region 101E or 201E of the molding 100E or the front cover 200E in the second direction Y may be provided to as half of the pitch p.

When the first display module 30A and the second display module 30E are disposed adjacent to each other in the second direction Y, first regions 101A and 201A of the molding 100A and the front cover 200A of the first display module 30A may be arranged to come in contact with the first regions 101E and 201E of the molding 100E and the front cover 200E of the second display module 30E.

A separation d (see FIG. 5) may exist between the first regions 101A and 201A of the molding 100A and the front cover 200A of the first display module 30A and the first regions 101E and 201E of the molding 100E and the front cover 200E of the second display module 30E, but the separation d is measured in micrometers, which is small enough to be ignored.

In this case, in an area between the first inorganic light emitting diode 50a and the third inorganic light emitting diode 50c, the edge 41e of the mounting surface 41 of the substrate 40 of the first display module 30A outside of the first inorganic light emitting diode 50a in the second direction Y, and the first region 101A and 201A of the molding 100A and the front cover 200A of the first display module 30A extending in the second direction Y, the edge 41e of the mounting surface 41 of the substrate 40 of the second display module 30E outside of the third inorganic light emitting diode 50c in the second direction Y, and the first region 101E and 201E of the molding 100E and the front cover 200E of the second display module 30E extending in the second direction Y may be disposed.

Accordingly, the distance between the first inorganic light emitting diode 50a and the third inorganic light emitting diode 50c may be obtained by the sum of a length L1 from the first inorganic light emitting diode 50a to the edge 41e in the second direction Y, a length L2 of the first region 101A or 201A of the molding 100A or the front cover 200A extending in the second direction Y, a length L1 from the third inorganic light emitting diode 50c to the edge 41e of the mounting surface 41 in the second direction Y, and a length L2 of the first region 101E or 201E of the molding 100E or the front cover 200E extending in the second direction Y.

Since the sum of L1 and L2 is formed at half the pitch p as described above, the distance between the first inorganic light emitting diode 50a and the third inorganic light emitting diode 50c may be formed as a pitch p.

The second layer 220 may be formed as a light transmittance control layer as described above, but the disclosure is not limited thereto, and the second layer 220 may be provided as a circular polarization layer. That is, the second layer 220 may include a polarizing member provided to polarize light incident from the outside. In addition, the second layer 220 may be formed of a material provided to pass only light in a specific polarization range and absorb light outside the specific polarization range.

Hereinafter, for the sake of convenience in description, the second layer 220 will be illustrated as a circular polarization layer 220. That is, the first layer 210 may be provided as an anti-glare layer 210 and the second layer 220 may be provided as a circular polarization layer 220.

The circular polarization layer 220 may pass only light having a specific phase in the transmitted light and absorb light having the other phase, thereby reducing the transmittance of light passing through the circular polarization layer 220.

The circular polarization layer 220 may include a linearly polarizing member and a circularly polarizing member. For example, the circular polarization layer 220 may be provided by overlapping a linear polarization film and a circular polarization film. The linear polarization film and the circular polarization film may be sequentially disposed in the first direction X.

In detail, the linearly polarizing film and the circular polarizing film of the circular polarization layer 220 may change the phase of external light incident from the outside of the display module 20. The circular polarization layer 220 prevents external light having a phase changed due to passing therethrough that is reflected from the substrate 40 or the gap G and then is redirected to the circular polarization layer 220 from passing through the circular polarization layer 220 based on the changed phase.

Accordingly, at least a part of external light incident on the display module 20 may be absorbed by the circular polarization layer 220 without being reflected to the outside. That is, the circular polarization layer 220 may pass only light having a specific phase in the transmitted light and absorb light having a phase out of the specific phase.

Accordingly, the circular polarization layer 220 absorbs part of light transmitted through the circular polarization layer 220 and reflected from the substrate 40 or the gap G, in particular, the light reflected from the gap G, to thereby lower the revelation of a seam perceived in the gap G.

As described above, when the second layer 220 is provided as the light transmittance control layer 220, the degree of transmission of light maybe adjusted by adjusting the transparency of the material of the second layer 220. In contrast, when the second layer 220 is provided as the circular polarization layer 220, the degree to which light reflected from the substrate 40 or the gap G is transmitted back to the outside again may be adjusted through the phase difference of light.

As described above, the molding 100 and the front cover 200 may be arranged in the gap G in the first direction X.

Accordingly, external light incident onto the display module 20 may pass through the anti-glare layer 210, the circular polarization layer 220, and the molding 100 to enter the gap G. In this case, the incident light may be diffusely reflected by the anti-glare layer 210 without entering the gap G, and only part of light having a specific phase is allowed to enter the gap G and the remaining is absorbed by the circular polarization layer 220.

In addition, the light reflected from the gap G may be directed to the outside by sequentially passing through the molding 100, the circular polarization layer 220, and the anti-glare layer 210, in which case light passing through the circular polarization layer 220 and having a phase out of a specific phase is absorbed by the circular polarization layer 220 without being transmitted to the outside.

As described above, the first layer 210 may be formed as an anti-glare layer, but is not limited thereto and may be formed as an anti-reflect layer. That is, the first layer 210 may include a material that reflects externally incident light to the outside of the display panel 20 that is not the direction of the substrate 40 or the gap G, or a configuration that reflects externally incident light to the outside of the display panel 20 that is not the direction of the substrate 40 or the gap G.

Hereinafter, for the sake of convenience in description, the first layer 210 will be illustrated as an anti-reflect layer 210. That is, the first layer 210 may be provided as an anti-reflect layer 210 and the second layer 220 may be provided as a light transmittance control layer 220.

As described above, the anti-reflect layer 210 may reflect external light incident onto the display panel 20 to the outside of the display panel 20 that is not the direction of the substrate 40 or the gap G. Accordingly, the amount of light passing through the anti-reflect layer 210 that is incident onto the gap G may be reduced.

Accordingly, the reflectance of external light incident onto the display panel 20 that is incident to the gap G is lowered, thereby improving the sense of unity of the screen of the display module 20.

The anti-reflect layer 210 may include a plurality of layers having different refractive indices. When external light is incident onto the anti-reflect layer 210, the external light may be subject to internal reflection due to the difference in refractive indices of the plurality of layers and thus travel to the outside of the display panel 20 rather than to the substrate 40 or the gap G.

Accordingly, the anti-reflect layer 210 allows only part of light transmitted therethrough to be transmitted to the substrate 40 or the gap G and absorbs the remaining light, in particular, part of the light directed to the gap G to thereby reduce the revelation of the seam perceived in the gap G and reduce the revelation of the boundary between the plurality of display modules 30A to 30P.

Conversely, the anti-reflect layer 210 may be provided such that light reflected from the gap G or the substrate 40 and incident onto the anti-reflect layer 210 is subject to internal reflection and thus prevented from being transmitted in the first direction X. For example, light from the gap G in the first direction X is transmitted in a direction corresponding to the second direction Y or the third direction Z by the anti-reflect layer 210, so that the reflectance of external light on the display panel 20 is reduced, and revelation of the boundary between the plurality of display modules 30A to 30P is reduced.

Accordingly, only a part of the light reflected from the substrate 40 or the gap G is transmitted through the anti-reflect layer 210, so that the revelation of the seam perceived in the gap G is reduced, and the sense of unity of the screen of the display panel 20 is improved.

As described above, when the first layer 210 is provided as the anti-glare layer 210, the reflectance of external light may be adjusted by allowing the external light to be diffusely reflected on the surface of the anti-glare layer 210, and when the first layer 210 is provided as the anti-reflect layer 210, the degree of transmission of light may be adjusted by adjusting the reflection direction of light through the anti-reflect layer 210.

Accordingly, external light incident onto the display module 20 may sequentially pass through the anti-reflect layer 210, the light transmittance control layer 220, and the molding 100 to enter the gap G. In this case, at least a part of the incident light may be prevented from entering the gap G due to the anti-reflect layer 210 and the light transmittance control layer 220.

In addition, light reflected from the gap G may be transmitted to the outside by sequentially passing through the molding 100, the light transmittance control layer 220, and the anti-reflect layer 210, in which a part of light passing through the light transmittance control layer 220 and the anti-reflect layer 210 may be prevented from being directed to the front of the display panel 20.

Hereinafter, a case where the first layer 210 is provided as the anti-reflect layer 210 and the second layer 220 is provided as the circular polarization layer 220 will be described.

For the sake of convenience in description, the first layer 210 will be illustrated an anti-reflect layer 210 and the second layer 220 will be illustrated as a circular polarization layer 220. That is, the first layer 210 may be provided as an anti-reflect layer 210 and the second layer 220 may be provided as a light transmittance control layer 220.

The anti-reflect layer 210 reflects external light incident onto the display panel 20 to the outside of the display panel 20 that is not the direction of the substrate 40 or the gap G to thereby reduce the amount of external light passing through the anti-reflect layer 210. Accordingly, the reflectance of external light introduced into the display panel 20 that is incident onto the gap G may be reduced, so that the sense of unity of the screen of the display module 20 may be improved.

The circular polarization layer 220 may pass only light having a specific phase in the transmitted light and absorb light having a phase out of the specific phase.

Accordingly, only a part of the light passing through the anti-reflect layer 210 is transmitted to the substrate 40 or the gap G, and the amount of light directed to the gap G is reduced due to internal reflection of the anti-reflect layer 210. Only a part of light transmitted through the anti-reflect layer 210 that has a specific phase may pass through the circular polarization layer 220 and move to the substrate 40 or the gap G, and the remaining light may be absorbed by the circular polarization layer 220.

Conversely, light reflected from the gap G or the substrate 40 and transmitted through the circular polarization layer 220 and the anti-reflect layer 210 is partially absorbed by the circular polarization layer 220 or is subject to internal reflection of the anti-reflect layer 210 without being transmitted in the first direction X, so that the reflectance of light reflected from the gap G in the display panel 20 is reduced, and thus the sense of unity of the screen of the display module 20 may be improved.

Accordingly, in particular, the amount of light directed to the gap G is reduced, so that the reflectance itself is reduced, and the amount of light reaching the gap G that is reflected to the outside of the display 20 is reduced, so that the revelation of the seam perceived in the gap G is reduced, and the sense of unity of the screen of the display module 20 may be improved.

Further, the disclosure is not limited to the above, and the first layer 210 may include both the anti-reflect layer and the anti-glare layer described above. That is, the first layer 210 may be configured in a stacked form such that an anti-reflect layer and an anti-glare layer are layered.

The anti-glare layer may diffusely reflect light incident onto the first layer 210 from the outside, and the anti-reflect layer may induce a reflection direction of light such that light incident onto the first layer 210 is reflected outside with respect to the first direction X of the display panel 20.

In this way, the first layer 210 may reduce the reflectance of external light incident onto the display panel 20 through the anti-glare layer and the anti-reflect layer.

The anti-glare layer and the anti-reflect reflective layer may be sequentially arranged in the first direction X.

When the first layer 210 is formed in a stacked structure of an anti-glare layer and an anti-reflect layer, the second layer 220 may be provided as a light transmittance control layer 220 as described above.

The second layer 220 provided as a light transmittance control layer may reduce the transmittance of incident external light or external light reflected from the substrate 40 and the gap G, as described above.

The first layer 210 and the second layer 220 are provided to allow only a part of light passing therethrough to be transmitted to the substrate 40 or the gap G.

The incident light may be diffusely reflected or direction-changed through internal reflection by the first layer 210, and may be absorbed by the second layer 220 so that the amount of light, in particular, light directed to the gap G may be reduced.

Conversely, when light reflected from the gap G or the substrate 40 sequentially passes through the second layer 220 and the first layer 210, the light may be absorbed by the second layer 220 or may be prevented from passing through the display panel 20 in the first direction X by the first layer 210.

Accordingly, as the amount of light, in particular, light directed to the gap G is reduced, the reflectance itself is reduced, and the amount of light reaching the gap G that is reflected from the gap G to the outside of the display module 20 is reduced, so that the revelation of a seam perceived in the gap G may be reduced, and the sense of unity of the screen of the display module 20 may be improved.

In addition, when the first layer 210 is formed in a stacked structure of an anti-reflect layer and an anti-glare layer, the second layer 220 may be provided as a circular polarization layer. As described above, the first layer 210 may reduce the reflectance of external light incident onto the display panel 20 through the anti-reflect layer and the anti-glare layer.

In addition, the second layer 220 may polarize external light passing therethrough, absorb external light having a phase out of a specific phase, and absorb external light reflected from the substrate 40 and the gap G that has a phase out of the specific phase to prevent the reflected external light from passing through the second layer 220. The front cover 200 is configured such that incident light is diffusely reflected or direction-changed through internal reflection by the first layer 210, and light passing through the first layer 210 and reaching the second layer 220 is polarized by the second layer 220 so that a part of light having a specific phase passes through the second layer 220 and the remaining light having a phase out of the specific phase is absorbed by the second layer 220. The front cover 200 may reduce the amount of light, in particular, light directed to the gap G so that the revelation of a seam perceived in the gap G may be reduced.

Conversely, as for at least a part of light reflected from the substrate G and the gap G that is transmitted through the circular polarization layer 220, light having a phase out of a specific phase is absorbed by the second layer 220 and isprevented from passing through the first layer 210 and exiting the display panel 20 in the first direction X.

Accordingly, as the amount of light, in particular, light directed to the gap G is reduced, the reflectance itself is reduced, and the amount of light reaching the gap G that is reflected from the gap G and directed to the display module 20 is reduced, so that the revelation of a seam perceived in the gap G may be reduced, and the sense of unity of the screen of the display module 20 may be improved.

Unlike the adhesive layer 230 described as being formed of a transparent material in the above, the adhesive layer 230 may be formed of a different component.

In detail, the adhesive layer 230 may be formed of a material capable of absorbing at least a portion of light transmitting through the adhesive layer 230. For example, the adhesive layer 230 may be partially opaque.

That is, the adhesive layer 230 may reduce the transmittance of light incident onto the adhesive layer 230 similar to the light transmittance control layer described above, to serve as a light transmittance control layer.

In this case, the second layer 220 may be provided as a transparent layer formed of a transparent material. Hereinafter, for the sake of convenience in description, the second layer 220 is illustrated as a transparent layer 220.

The transparent layer 220 may be disposed between the first layer 210 and the adhesive layer 230.

The transparent layer 220 may be in a highly transparent state having a transmittance of 90% or more, such as an optical clean resin (OCR).

This is because the adhesive layer 230 lowers the transmittance of light passing through the display panel 20, further lowering of the transmittance of light may lower the brightness of the screen of the display panel 20 itself.

Accordingly, the transparent layer 220 may be formed of a transparent material so that light incident onto the transparent layer 220 is easily transmitted therethrough.

The disclosure is not limited thereto, and the transparent layer 280 may be omitted from the front cover 200.

In this case, the first layer 210 may be provided in any one structure including an anti-glare layer, an anti-reflect layer, or an anti-glare layer and anti-reflect layer stacked on each other.

The front cover 200 may allow only a part of light transmitted through the first layer 210, the transparent layer 220, and the adhesive layer 230 to be transmitted to the substrate 40 or the gap G.

With the front cover 200, incident light is diffusely reflected or is deflected by the first layer 210 and then is absorbed by the adhesive layer 230 so that the amount of light directed to the gap G may be reduced. Conversely, with the front cover 200, at least a part of light reflected from the gap G or the substrate 40 is absorbed by the adhesive layer 230 and so as not to pass through the first layer 210 and the display panel 20 in the first direction X.

Accordingly, as the amount of light, in particular, light directed to the gap G is reduced, the reflectance itself is lowered, and the amount of light reaching the gap G that is reflected from the gap G to the outside of the display module 20 is reduced, the revelation of a seam in the gap G may be reduced and the sense of unity of the screen of the display module 20 may be improved. Hereinafter, a method of manufacturing a display apparatus according to an embodiment of the disclosure will be briefly described with reference to FIGS. 1 to 7.

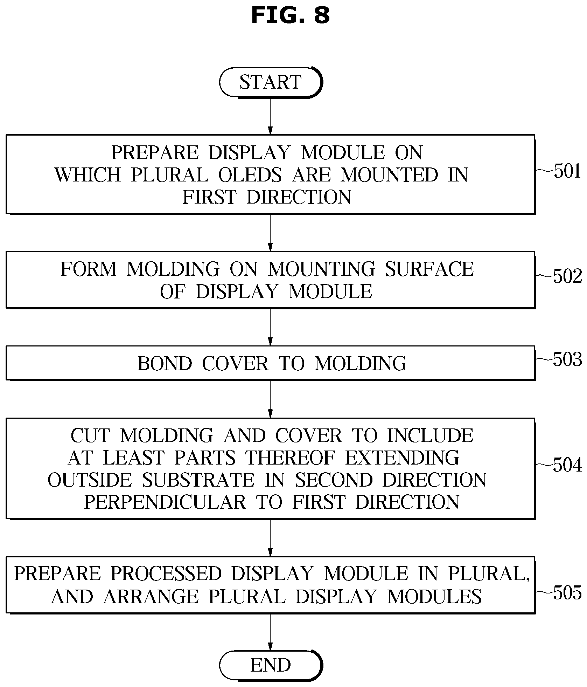

FIG. 8 is a flowchart showing a method of manufacturing a display apparatus according to an embodiment of the disclosure.

First, a display module 30 including a plurality of inorganic light emitting diodes 50 is prepared (operation 501). The plurality of inorganic light emitting diodes 50 are mounted on a mounting surface 41 of a substrate 40 of the display module 30. In order to improve contrast between colors generated by red, green, and blue inorganic light emitting diodes 50, the substrate 40 may include a light absorbing layer 60. The substrate 40 may also include an anisotropic conductive layer 70 so that the plurality of inorganic light emitting diodes 50 are electrically connected to the substrate 40.

In addition, the black matrix 80 may be formed on the anisotropic conductive layers 70 of the plurality of display modules 30A to 30P.

Next, the molding 100 is formed on the mounting surface 41 of the display module 30 (operation 502). The molding 100 may cover the entire area of the substrate 40, including the mounting surface 41. The molding 100 may be formed through a compression hardening process on the mounting surface 41.

The molding 100 may cover not only the mounting surface 41, but also the chamfer portion 49 and the side surface 45 of the substrate 40.

Next, the front cover 200 is bonded to the molding 100 (operation 503). The front cover 200 includes the bonding layer 230 provided to be bonded to the molding 100, and the front cover 200 may be bonded to the outer surface of the molding 100 by the bonding layer 230.

Next, the molding 100 and the front cover 200 are cut such that at least portions of the molding 100 and the front cover 200 extend outside of the substrate 40 in the second direction Y perpendicular to the first direction X facing the mounting surface 41 (operation 504).

In detail, the molding 100 and the front cover 200 may be cut to form the first regions 101 and 201 of the molding 100 and the front cover 200 outside the mounting surface 41 in the second direction Y.

The cutting process may be performed by laser cutting or the like.

The cutting process may also be performed to form the first regions 101 and 201 of the molding 100 and the front cover 200 outside the mounting surface 41 in the third direction Z perpendicular to the first direction X and the second direction Y, in addition to the second direction Y.

That is, the molding 100 and the front cover 200 may be cut to have the first regions 101 and 201 extending outward of the four sides of the mounting surface 41.

In an embodiment, the molding 100 and the front cover 200 may be cut in the first direction X. In this manner, when the plurality of display modules 30A to 30P are tiled, a gap between the display modules 30A to 30P may be minimized as described above.

In addition, when the molding 100 and the front cover 200 are cut obliquely with respect to the first direction X and the plurality of display modules 30A to 30P are tiled, the molding 100 or the front cover 200 may fail to be disposed in the gap G formed between the plurality of display modules 30A to 30P.

In the cutting process, the first regions 101 and 201 extending outside the mounting surface 41 may be processed to have a length smaller than or equal to approximately half of a length of a gap formed between the display modules 30 that may be provided a plurality of display modules 30A to 30P.

Next, the display module 30 processed as the above may be prepared as a plurality of the display modules 30A to 30P, and the plurality of display modules 30A to 30P may be disposed adjacent to each other (operation 505). In this case, the plurality of display modules 30A to 30P may be fixed through a jig. The plurality of display modules 30A to 30P may be arranged in an M ^{∗} N matrix form.

Accordingly, when the plurality of display modules 30A to 30P are arranged adjacent to each other, the first regions 101 and 201 of the molding 100 and the front cover 200 extending from each of the display modules 30A to 30P may be disposed in the gap G formed between the plurality of display modules 30A to 30P.

Hereinafter, a display apparatus according to another embodiment of the disclosure will be described. Components other than a molding 100 and a front cover 300 to be described below are the same as those of the display apparatus 1 according to the above-described embodiments, and thus descriptions thereof will be omitted.

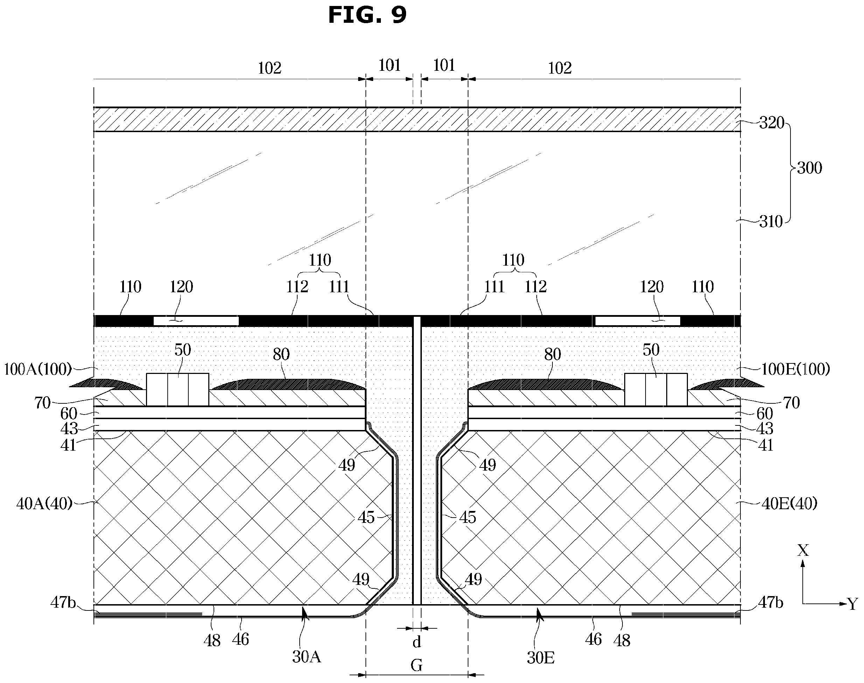

FIG. 9 is an enlarged cross-sectional view illustrating some components of a display apparatus according to another embodiment of the disclosure.

The molding 100 may include a light absorption pattern 110 formed on an upper surface of the molding 100 in the first direction X and configured to absorb light directed to the substrate 40 or the gap G.

The light absorption pattern 110 may be formed of a material similar to the black matrix 80.

The light absorption pattern 110 may be formed in a lattice shape having a horizontal pattern and a vertical pattern to be disposed between pixels in the first direction X.

The light absorption pattern 110 may be formed by applying a light-absorbing ink on the molding 100 through an ink-jet process and then curing the light-absorbing ink, or may be formed by coating a light-absorbing film on the molding 100.

That is, the light-absorbing pattern 110 may be located in a space corresponding, in the first direction X, to a space between the plurality of inorganic light emitting diodes 50 in which the plurality of inorganic light emitting diodes 50 are not mounted.

The light absorption pattern 110 may be formed of a black-based material that absorbs light effectively in order to maximize the light absorption effect. In an embodiment, the light absorption pattern 110 may have a color corresponding to the black matrix 80.

In order to emphasize that the light absorption pattern 110 is a component formed on the upper surface of the molding 100 that is discriminated from the black matrix 80 formed on the mounting surface 41, the light absorption pattern 110 is named as such, but the light absorption pattern 110 may have the same component as the black matrix 80.

The light absorption pattern 110 may be disposed at a position corresponding to the black matrix 80 in the first direction X.

The light absorption pattern 110 may not be disposed at a position, in which the plurality of inorganic light emitting diodes 50 are disposed, in the first direction X. This is to prevent light emitted from the plurality of inorganic light emitting diodes 50 from being absorbed by the light absorption pattern 110. Accordingly, the light efficiency of the display panel 20 may be increased.

Additionally, the light absorption pattern 110 may extend to the outside of the substrate 40 in the second direction Y.

That is, the light absorption pattern 110 may include a first region 101 corresponding to the first region 101 of the molding 100 in the first direction X and a second region 112 corresponding to the second region 102 of the molding 100 in the first direction X.

Light incident onto the display panel 20 that is directed to the gap G may be absorbed by the first region 111 of the light absorption pattern 110.

In addition, light reflected from the gap G may be absorbed by the first region 111 of the light absorption pattern 110. Accordingly, as the first region 111 of the light absorption pattern 110 capable of absorbing light is disposed in the gap G in the first direction X, the revelation of a seam perceived in the gap G may be reduced and the sense of unity of the screen of the display panel 20 may be increased.

The front cover 300 may be disposed on the plurality of display modules 30A to 30P in the first direction X.

Unlike the front cover 200 disclosed in the one embodiment and the another embodiment of the disclosure described above, the front cover 300 according to the embodiment of the disclosure may be formed as a single unit.

That is, in the case of the front cover 200 disclosed in the one embodiment and the another embodiment of the disclosure, the front covers 200 are formed on the plurality of display modules 30A to 30P so that when the display modules 30A to 30P are tiled, the front covers 220 are also provided to be tiled

However, the front cover 300 according to the disclosure is formed as a single unit, and may be disposed on the plurality of display modules 30A to 30P after the plurality of display modules 30A to 30P are tiled.

The front cover 300 may include a cover glass 310 provided to protect the substrate 40 from external force and a front layer 320 disposed on an upper side of the cover glass 310 in the first direction X and configured to absorb at least part of light incident onto the front cover 300 or adjust the reflection direction of the light to reduce light transmittance.

The front layer 320 may include at least one of the anti-glare layer, the anti-reflect layer, the circular polarization layer, or the light transmittance control layer described in the above embodiments of the disclosure.

As is apparent from the above, the display apparatus according to the embodiment absorbs light incident onto or reflected from a gap between display modules adjacent to each other, thereby providing a seamless effect that a seam is prevented from being visually perceived.

The display apparatus according to the embodiment of the disclosure includes a plurality of display modules that individually include components configured to absorb light incident onto or reflected from a gap between adjacent display modules, thereby easily and efficiently implementing the seamless effect even when assembled.

The foregoing exemplary embodiments are merely exemplary and are not to be construed as limiting. The present teaching can be readily applied to other types of apparatuses. Also, the description of the exemplary embodiments is intended to be illustrative, and not to limit the scope of the claims, and many alternatives, modifications, and variations will be apparent to those skilled in the art.

## Claims

1. A display module comprising:
a substrate comprising:
a mounting surface on which a thin film transistor (TFT) layer is formed,
a side surface, and
a chamfer portion formed between the mounting surface and the side surface;
a plurality of inorganic light emitting diodes (LEDs), each of the plurality of inorganic LEDs comprising:
a pair of electrodes electrically connected to the TFT layer and disposed at one side of each of the plurality of inorganic LEDs to face the mounting surface, and
a light emitting surface configured to emit light in a first direction opposite to a second direction that extends from the plurality of inorganic LEDs to the mounting surface of the substrate, and disposed at the other side of each of the plurality of inorganic LEDs which is opposite side of the one side of each of the plurality of inorganic LEDs; and
a molding provided to cover the plurality of inorganic LEDs, the chamfer portion of the substrate, and the side surface of the substrate.

2. The display module of claim 1, wherein the mounting surface comprises four edges, and one of the four edges corresponds to the side surface, and
the molding is provided to cover the four edges of the mounting surface.

3. The display module of claim 2, further comprising a printed circuit board (PCB) configured to electrically control the plurality of inorganic LEDs,
wherein the PCB is arranged on a rear surface of the substrate that is disposed to be opposite to the mounting surface, and
the molding is provided to surround the mounting surface, the chamfer portion, and the side surface.

4. The display module of claim 1, further comprising a cover arranged on an upper surface of the molding,
wherein the molding has a first surface area larger than a second surface area of the mounting surface of the substrate, and the cover has a third surface area equal to or larger than the first surface area of the molding.

5. The display module of claim 1, further comprising a cover arranged on an upper surface of the molding,
wherein the cover comprises:
a cover glass; and
a circular polarization layer arranged in front of the cover glass and configured to circularly polarize light that is transmitted through the circular polarization layer.

6. The display module of claim 5, wherein the display module further comprises a light absorbing pattern arranged between the molding and the cover glass, and a black matrix formed between the plurality of inorganic LEDs on the mounting surface, and wherein the light absorbing pattern is located at a position corresponding to a position of the black matrix in a third direction in which the mounting surface faces.

7. The display module of claim 6, wherein the light absorbing pattern is provided to extend outside the side surface in a fourth direction perpendicular to the third direction in which the mounting surface faces.

8. The display module of claim 1, further comprising a cover arranged on an upper surface of the molding,
wherein the cover comprises:
a first layer, and
a second layer stacked on the first layer and located at a rear side of the first layer in the first direction.

9. The display module of claim 8, wherein the first layer comprises at least one of an anti-glare layer provided to diffusely reflect an incident light or an anti-reflect layer provided to change a reflection direction of the incident light.

10. The display module of claim 8, wherein the second layer comprises a material that lowers transmission of an incident light that is incident on the second layer and then is transmitted through the second layer.

11. The display module of claim 10, wherein the second layer comprises a circular polarization layer.

12. The display module of claim 1, further comprising a black matrix arranged between the plurality of inorganic LEDs.

13. The display module of claim 1, wherein each of the plurality of inorganic LEDs further comprises a bottom surface formed at a side opposite to the light emitting surface,
wherein the pair of electrodes are arranged on the bottom surface.

14. A display apparatus comprising a display module array in which a plurality of display modules are arranged in a M X N matrix,
wherein M and N are natural numbers, and
wherein each of the plurality of display modules comprises:
a substrate comprising:
a mounting surface on which a thin film transistor (TFT) layer is formed, a side surface, and
a chamfer portion formed between the mounting surface and the side surface; a plurality of inorganic light emitting diodes (LEDs), each of the plurality of inorganic LEDs comprising:
a pair of electrodes electrically connected to the TFT layer and disposed at one side of each of the plurality of inorganic LEDs to face the mounting surface, and
a light emitting surface configured to emit light in a first direction opposite to a second direction that extends from the plurality of inorganic LEDs to the mounting surface of the substrate, and disposed at the other side of each of the plurality of inorganic LEDs which is opposite side of the one side of each of the plurality of inorganic LEDs; and
a molding provided to cover the plurality of inorganic LEDs, the chamfer portion of the substrate, and the side surface of the substrate, and
a cover arranged on an upper surface of the molding in a direction in which the light emitting surface faces.

15. The display apparatus of claim 14, wherein each of the plurality of display modules further comprises
a printed circuit board (PCB) provided to drive the plurality of inorganic LEDs and disposed at a side opposite to the mounting surface, and
a wiring connecting the plurality of inorganic LEDs to the PCB and extending along the side surface,
wherein the molding is provided to cover the wiring extending on the side surface.
